# EUROPEAN PATENT APPLICATION

(11) **EP 2 399 694 A1**
(43) Date of publication of application: **28.12.2011**
(21) Application number: 10743787.3
(22) Date of filing: 17.02.2010
(51) Int. Cl.: B22F 1/00, B22F 1/02, B22F 9/02, B22F 9/08, B22F 9/24, B82B 1/00, B82B 3/00, C25D 11/18, C25D 11/20

(54) **METAL MEMBER**

(30) Priority: 17.02.2009 JP 2009034211
(71) Applicant: FUJIFILM Corporation, Tokyo 106-0031 (JP)
(72) Inventor: TOMITA Tadabumi, Haibara-gun Shizuoka 4210396 (JP); HOTTA Yoshinori, Haibara-gun Shizuoka 421-0396 (JP)
(74) Representative: HOFFMANN EITLE
(86) International application number: PCT/JP2010/052371
(87) International publication number: WO 2010/095661

(57) **Abstract**

High aspect-ratio metal members such as a nanopillar, a nanorod, and the like, and a method of producing the same. The present invention provides high aspect-ratio metal members such as a nanopillar or a nanorod, and a method of producing the same, such metal members being produced by filling the micropores of an anodized film having a degree of ordering of 70% or more with a metal having an aspect ratio of 5 or more, followed by baking in inert gas atmosphere or in a vacuum at 300°C or more to 1000°C or less to improve crystallinity.

## Description

### TECHNICAL FIELD

The present invention relates to high aspect-ratio metal members such as a nanopillar, a nanorod, and the like, and a method of producing the same.

### BACKGROUND ART

A nanopillar refers to a structure having regularly arranged columns (pillars) of the order of nanometers. A nanorod, also referred to as nanowire, is exemplified characteristically by a rod-shaped metallic particle. Nanorods regularly formed on a substrate are also referred to as nanopillar. Such nanoparticles exhibit whole different physical properties from bulks due to quantum confinement effect and, when used in manufacture of electronic devices such as semiconductors and fluorescent bodies, are expected to dramatically improve their properties.

Patent Literature 1 describes a nanopillar structure produced by filling a substance into micropores in the anodized film structure for transfer where micropores are regularly arranged.
Patent Literature 2 describes manufacture of metallic nanowires using like anodized film.

Patent Literature 3 describes inorganic nanowires that are inorganic nanowires from which the organic scaffold has been substantially removed and which are thus essentially composed of fused inorganic nanoparticles containing virtually no organic scaffold. Gene manipulation virus scaffold serves as a template when nanoparticles or nanocrystals are formed on the scaffold.
Patent Literature 3 describes heat treating isolated metallic nanowires.
Patent Literature 4 describes heat treating isolated metallic nanowires.

### CITATION LIST

### PATENT LITERATURE

Patent Literature 1: JP 2006-62049 A
Patent Literature 2: JP 2005-256102 A
Patent Literature 3: JP 2007-525395 A
Patent Literature 4: JP 2008-192680 A

### SUMMARY OF INVENTION

### TECHNICAL PROBLEMS

A method whereby a nanomaterial having a given configuration can be produced at a given position on a substrate by electrolysis using a direct-current low voltage. That is, using a porous alumina as a template in manufacture of a nanomaterial is an already known, prior art technique. However, development of nanopillars and nonorods having still better properties is desired in a variety of applications.

### SOLUTION TO PROBLEMS

The present inventors focused their efforts on research in order to achieve the above objects, found that applying heating treatment to nanorods and nanopillars can improve their crystallinity and electromagnetic properties, and have completed the invention.
They also found that coating a part or the whole of a nanopillar or nanorod metal members with a noble metal can further improve the electromagnetic properties and have completed the invention.

Specifically, the present invention provides the following (1) to (6).
(1) Metal members produced by filling the micropores of an anodized film having a degree of ordering of 70% or more with a metal having an aspect ratio of 5 or more, followed by baking in inert gas atmosphere or in a vacuum at a temperature from 300°C or more to 1000°C or less to improve crystallinity.
(2) Nanopillar or nanorod metal members that are metal members having an aspect ratio of 5 or more produced by filling the micropores of an anodized film having a degree of ordering of 70% or more with a metal having an aspect ratio of 5 or more, followed by baking in inert gas atmosphere or in a vacuum at a temperature from 300°C or more to 1000°C or less to improve crystallinity and removing the anodized film.
(3) Metal members where a part or the whole of the metal members are coated by at least one kind of noble metal, the metal members being nanopillars or nanorod metal members having a diameter of 0.02 µm to 0.4 µm, a length of 10 µm to 200 µm, and an aspect ratio of 5 or more.
(4) A method of producing metal members having an aspect ratio of 5 or more, the method comprising filling a metal in the micropores of an anodized film to an aspect ratio of 5 or more, followed by baking in inert gas atmosphere or in a vacuum at a temperature from 300°C or more to 1000°C or less to improve crystallinity and removing the anodized film.
(5) A method of producing nanopillar or nanorod metal members comprising filling a metal in the micropores of an anodized film to an aspect ratio of 5 or more, melting a part of the anodized film to expose the metal, coating the exposed region with a different kind of metal, and thereafter melting the anodized film.
(6) The method of producing a metal member described in (5) above, wherein the step of melting a part of the anodized film to expose the metal and the step of coating the exposed region with a different kind of metal are repeated twice or more.
(7) A probe needle using the metal members described in (1) or (3) above.
(8) A magnetic substance for magnetic separation or magnetic chromatography using the metal members described in (1) or (3) above.
(9) A nanobarcode using the metal members described in (3) above.
(10) An anisotropic conductive member obtained by orientating the nanorods described in (2) or (3) above in a resin using magnetic afield.

### ADVANTAGEOUS EFFECTS OF INVENTION

The present invention, related to nanopillar metal members or nanorod metal members having an improved crystallinity, can, when used for a magnetic recording medium, a light emitting element, or the like, enhance their performance.
Further, the present invention, also related to nanopillar metal members or nanorod metal members having a part or the whole thereof coated by a noble metal, is of great utility as a probe for an SPM (Scanning Probe Microscope) or a probe needle of a probe card used for semiconductor inspection, a nanobaroode, and a nanotag.

### BRIEF DESCRIPTION OF DRAWINGS

[FIG. 1] FIGS. 1A and 1B are simplified views showing a preferred embodiment of metal members of the invention; FIG. 1A is a front view and FIG. 1B is a cross-sectional view taken along the line IB-IB of FIG. 1A.
[FIG. 2] FIG. 2 is a cross sectional view for explaining first metal members of the invention: FIG. 2A is a cross sectional view of nanopillar metal members of the invention; FIG. 2B is a cross sectional view of a nanorod metal member of the invention.
[FIG. 3] FIG. 3 is a cross sectional view for explaining second metal members of the invention: FIG. 3A is a cross sectional view of nanopillar metal members of the invention; FIG. 3B is a cross sectional view of a nanorod metal member of the invention.
[FIG. 4] FIG. 4 is a cross sectional view for explaining another embodiment of metal members of the invention: FIG. 4A is a cross sectional view of nanopillar metal members of the invention;
FIG. 4B is a cross sectional view of a nanorod, metal member of the invention.

### DESCRIPTION OF EMBODIMENTS

The first metal members of the invention are metal members obtained by filling a metal in micropores existing in an anodized film having a degree of ordering of 70% or more at a density of 2 million pcs/mm² or more to an aspect ratio of 5 or more, followed by a heating treatment to improve crystallinity.
The second metal members of the invention are metal members, wherein a part or the whole of the metal members are coated by a noble metal, the metal members being nanopillar or nanorod metal members having a diameter of 0.02 µm to 0.3 µm, a length of 10 µm to 200 µm, and an aspect ratio of 5 or more.

Now, the metal members and its production method according to the invention will be described in detail.
The first and the second metal members of the invention may each be nanopillar metal members where numerous pillars are erected substantially perpendicularly on a metallic or nonmetallic substrate. Alternatively, they may each be a separate nanorod metal member where such nanopillar metal members are separated from the substrate. Alternatively, the configuration may be such that numerous metallic pillars so pierce an insulating base in its thickness direction that one end of each of said metallic pillars project from one of the surfaces of said insulating base, and the other end of each of said metallic pillars project from the other surface of the insulating base.

### [Metal Member]

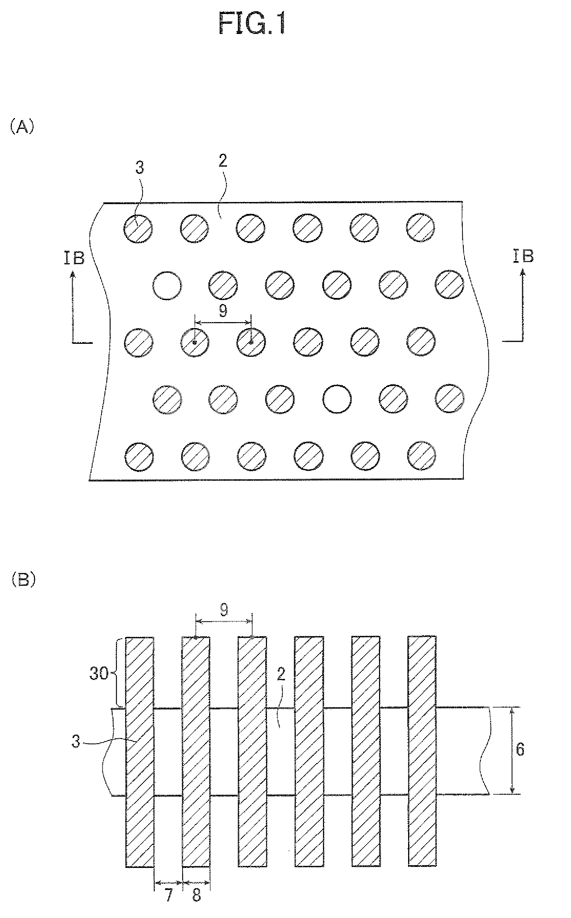

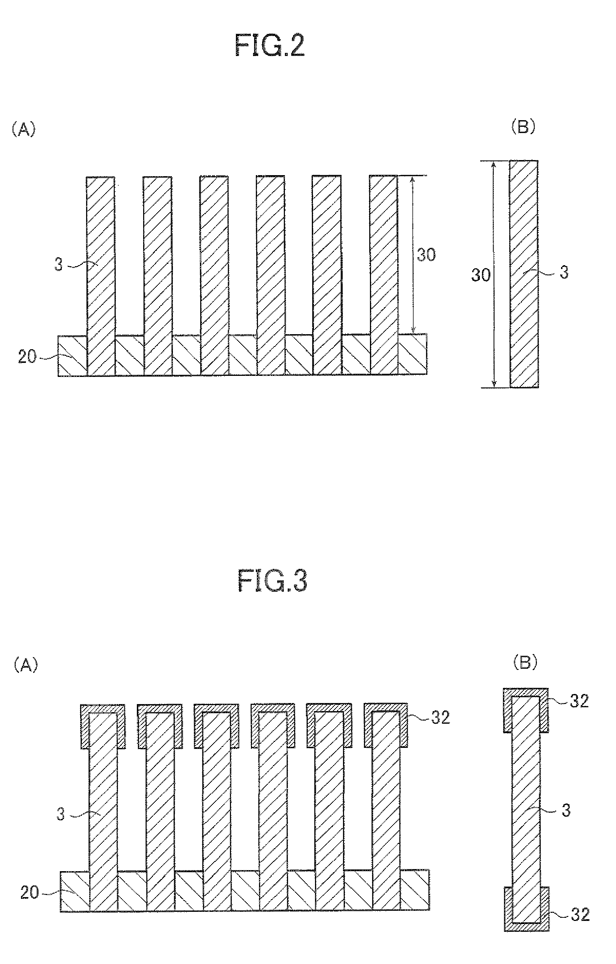

FIGS. 1 and 2 show simplified views of an example of a preferred embodiment of the first metal member. FIG. 1A is a front view; FIG. 1B is a cross-sectional view taken along the line IB-IB of FIG. 1A.
The first metal members 1 of the invention may be a nanopillar wherein numerous columnar metal members 3 are regularly erected on a base 20 as illustrated in FIG. 2A, or may be a separate nanorod metal member 3 as illustrated in FIG. 2B. Alternatively, as illustrated in FIG. 1, it may comprise a plurality of metal members 3 in the insulating base 2.
The metal members 3 preferably have a length equal to or longer than the length of a thickness 6 (thickness) of the insulating base 2 and are provided preferably at a density of 1 million pcs/mm² to 40 million pcs/mm², more preferably 1.5 million pcs/mm² to 40 million pcs/mm², and most preferably 2 million pcs/mm² to 30 million pcs/mm².
In these ranges, a high-aspect nanorod or nanopillars can be easily produced.
Preferably, the metal members 3 are provided so that at least the portions thereof embedded in the insulating base 2 are substantially parallel (parallel in FIG. 1) to the thickness direction of the insulating base 2.

The first and the second metal members 3 of the invention have an aspect ratio of 5 or more. The range of height/diameter = aspect ratio of the columnar metal members is 5 or more, preferably 10 or more, more preferably 40 or more, and still more preferably 2500 or less. With an aspect ratio in these ranges, the invention is useful for applications related to, for example, probes.

Preferred examples of metal of which the metal members may be made include gold (Au), silver (Ag), platinum (Pt), copper (Cu), iron (Fe), cobalt (Co), aluminum (Al), magnesium (Mg), and nickel (Ni). Gold, silver, and platinum are noble metals having catalysis and unique optical properties; copper is highly conductive; iron, nickel, cobalt, and the like are ferromagnetic metals useful as metal members of the nanopillar or the nanorod, of the invention. Among them, copper, gold, aluminum, and nickel, are preferably used as the metal members, particularly copper and gold.

The first metal members of the invention have an improved crystallinity owing to the heating treatment described later. Preferably, the crystallites therein measure 101 nm or more as calculated from Scherrer equation using a measuring method described below.

### <Evaluation of Crystallinity and Surface Oxidization>

The crystal size can be measured by measuring the line width in X-ray diffraction. Because the profile of the diffraction line is the total sum of the line widths of the individual crystal forms, it is known that the diffraction line widens as the crystallites grow smaller in size. The size of the crystallises D can be calculated by subtracting a line width unique to a device and dependent on the diffraction angle using data of a sample in which the crystallites are sufficiently large and there is no lattice distortion and substituting the half-value width of the measured diffraction line in the Scherrer equation.
The peak of the strongest diffraction line was used. Measurement is made using a sample free from the effects of oxidation. Samples where oxidation has progressed can be known from the fact that therein the diffraction line of a metal oxide is detected besides that of a metal.

$\begin{matrix}Scherrer Equation \\ Size of crystallite D \left[Å\right] = K x λ / \left(β x cosθ\right)\end{matrix}$
K: Scherrer constant, λ: wavelength of a used X-ray tube,
β: half-value width of diffraction line
θ: diffraction angle

In the present invention, the metal members are columnar and have a diameter (portion indicated by reference symbol 8 in FIG. 1B) of preferably 20 nm to 400 nm, more preferably 20 nm to 300 nm, 40 nm to 200 nm, and still more preferably 50 to 100 nm. With the metal member diameter in the above-defined range, when electrical signals are allowed to flow, a sufficient response can be obtained, and therefore the metal members of the present invention can be more advantageously used as a testing connector for electronic components.

In the present invention, the center-to-center distance between adjacent metal members (portion indicated by reference symbol 9 in FIG. 1 and referred to also as "pitch" below) is preferably 20 nm to 500 nm, more preferably 40 nm to 200 nm, and still more preferably 50 nm to 140 nm. The pitch in the above-defined range makes it easier to achieve a balance between the diameter of the metal members and the thickness of the separating wall of the insulating base.

The length of the metal members (portions indicated by reference symbol 30 in FIGS. 1 and 2), which may be selected from a variety of kinds according to the use, is preferably 10 µm to 200 µm.

Preferably, the insulating base 2 has a thickness of 30 µm to 1000 µm, and the metal members have a diameter of 5 nm to 500 nm as described above because electrical conduction can then be verified at a high density while high insulating properties are maintained.

In the first metal members of the invention, the insulating base has a degree of ordering, as defined for micropores by the equation (i) below, of 70% or more. Preferably, it is 75% or more, and more preferably 80% or more. While the upper limit of the degree of ordering is 100%, when pits are formed by an artificial method such as nano-imprint method or an FIB method prior to formation of the anodized film as starting points in forming micropores, a degree of ordering of nearly 100% can be attained whereas when such starting prints are formed by a self-ordering, a degree of ordering achieved is about 98% because a discontinuous boundary called domain spontaneously occurs.
Witch the degree of ordering held in this range, the crystallinity of the first metal members of the invention is high.

$Degree of ordering \left(%\right) = B / A \times 100$ In the above equation (i), A represents the total number of micropores in a measurement region. B represents the number of specific micropores in the measurement region for which, when a circle is drawn so as to be centered on the center of gravity of a substantial circle in a cross section of a specific micropore and so as to be of the smallest radius that is internally tangent to the edge of another micropore, the circle includes centers of gravity of six micropores other than the specific micropore. A method of measuring the degree of ordering is described in detail in JP 2008-270157 A.

### [Insulating Base]

The insulating base constituting a part of the metal members is a structure that comprises an anodized film on an aluminum substrate having micropores.
Alumina, used here as a material of the anodized film of aluminum, has an electric resistivity of about 10¹⁴Ω•cm as does, for example, thermoplastic elastomer.

In the present invention, the insulating base preferably has a thickness (portion indicated by reference symbol 6 in FIG. 1B) of from 10 µm to 2000 µm, more preferably from 50 µm to 1500 µm and still more preferably from 100 µm to 1000 µm. With the insulating base having a thickness in the foregoing range, the insulating base can be handled with ease.

In the present invention, the width between said metal members 3 (portion indicated by reference symbol 7 in FIG. 1B) in the insulating base is preferably 10 nm, or more, preferably 30 nm or more, and most preferably 50 nm or more. The upper limit is preferably 200 nm or less, more preferably 180 nm or less, and most preferably 150 nm or less.
With said width in the insulating base in this range, the adjacent pillars are less likely to come into contact with each other and can stand independently even when the aspect ratio of the metal members is high.

In the present invention, the insulating base can be produced, for example, by anodizing the aluminum substrate and perforating the micropores formed by anodization.
The anodizing treatment step and the perforating treatment step will be described in detail in connection with the production method described later.

### <Method of Producing First Metal members of the Invention>

A preferred method of producing the first metal members of the invention at least comprises:
(1) an anodizing treatment step in which an aluminum substrate is anodized to form an alumina film having micropores and having a degree of ordering of 70% or more;
(2) a perforating treatment step in which micropores formed by anodization are perforated after the anodizing treatment step to obtain an insulating base; and
(3) a metal filling step in which a metal is filled into perforated pores in the resulting insulating base after the perforating treatment step; and
(4) a step in which heating is carried out in inert gas atmosphere at a temperature from 300°C or more to 1000°C or less to improve crystallinity. Where necessary, the production method further comprises:
(5) an anodized film removing step of removing a part or the whole of the anodized film to obtain nanopillar metal members or a nanorod mental member having an aspect ratio of 5 or more with an improved crystallinity.

### [Aluminum Substrate]

The aluminum substrate that may be used in the inventive production method is not subject to any particular limitation. Illustrative examples include pure aluminum plate; alloy plates composed primarily of aluminum and containing trace amounts of other elements; substrates made of low-purity aluminum (e.g., recycled material) on which high-purity aluminum has been vapor-deposited; substrates such as silicon wafers, quartz or glass whose surface has been covered by high-purity aluminum by a process such as vapor deposition or sputtering; and resin substrates on which aluminum has been laminated.

According to the production method of the invention, the surface of the aluminum substrate on which an anodized film is provided by anodization treatment step described later preferably has an aluminum purity of 95.0 mass% or more, more preferably 99.5 mass% or more, and still more preferably 99.99 mass% or more. It is preferable for the aluminum purity to fall within the above range, because the orderliness of the micropore array is improved.

According to the production method of the present invention, the surface of the aluminum substrate that undergoes the subsequently described anodizing treatment step is preferably subjected beforehand to degreasing treatment and mirror finish treatment.

### [Heating Treatment]

Heading treatment is preferably carried out at a temperature of from 200°C to 350°C for a period of about 30 seconds to 2 minutes. Such heat treatment improves the orderliness of the array of micropores formed by the subsequently described anodizing treatment step.
Following the heating treatment, it is preferable to rapidly cool the aluminum substrate. The cooling method is exemplified by a method involving direct immersion of the aluminum substrate in, for example, water.

### [Degreasing Treatment]

Degreasing treatment is carried out using, for example, an acid, alkali or organic solvent, so as to dissolve and remove organic substances, including dust, grease and resins, adhering to the aluminum substrate surface, and thereby prevent defects due to organic substances from occurring in each of the treatments described later.

Preferred degreasing methods include the following: a method in which an organic solvent such as alcohol (e.g., methanol), ketone (e.g., methyl ethyl ketone), petroleum benzin or volatile oil is contacted with the surface of the aluminum substrate at ambient temperature (organic solvent method); a method in which a liquid containing a surfactant such as soap or a neutral detergent is contacted with the surface of the aluminum substrate at a temperature of from ambient temperature to 80°C, after which the surface is rinsed with water (surfactant method); a method in which an aqueous sulfuric acid solution having a concentration of 10 g/L to 200 g/L is contacted with the surface of the aluminum substrate at a temperature of from ambient temperature to 70°C for a period of 30 seconds to 80 seconds, following which the surface is rinsed with water; a method in which an aqueous solution of sodium hydroxide having a concentration of 5g/L to 20 g/L is contacted with the surface of the aluminum substrate at ambient temperature for about 30 seconds while electrolysis is carried out by passing direct current through the aluminum substrate surface as the cathode at a current density of 1 A/dm² to 10 A/dm², following which the surface is contacted with an aqueous solution of nitric acid having a concentration of 100 g/L to 500 and thereby neutralized; a method in which any of various known anodizing electrolytic solutions is contacted with the surface of the aluminum substrate at ambient temperature while electrolysis is carried out by passing a direct current at a current density of 1 A/dm² to 10 A/dm² through the aluminum substrate surface as the cathode or by passing alternating current through the aluminum substrate surface as the cathode; a method in which an aqueous alkali solution having a concentration of 10 g/L to 200 g/L is contacted with the surface of the aluminum substrate at 40°C to 50°C for 15 seconds to 60 seconds, following which an aqueous solution of nitric acid having a concentration of 100 g/L to 500 g/L is contacted with the surface and thereby neutralized; a method in which an emulsion prepared by mixing a surfactant, water and the like into an oil such as gas oil or kerosene is contacted with the surface of the aluminum substrate at a temperature of from ambient temperature to 50°C, following which the surface is rinsed with water (emulsion degreasing method); and a method in which a mixed solution of, for example, sodium carbonate, phosphates and surfactant is contacted with the surface of the aluminum substrate at a temperature of from ambient temperature to 50°C for 30 seconds to 180 seconds, following which the surface is rinsed with water (phosphate method) .

Of these, the organic solvent method, surfactant method, emulsion degreasing method and phosphate method are preferred from the standpoint of removing grease from the aluminum surface while causing substantially no aluminum dissolution.

Known degreasers may be used in the degreasing treatment. For example, the degreasing treatment may be carried out using any of various commercially available degreasers by the prescribed method.

### [Mirror Finishing Treatment]

Mirror finishing treatment is carried out to eliminate surface asperities of the aluminum substrate and improve the uniformity and reproducibility of particle-forming treatment using, for example, electrodeposition. Exemplary surface asperities of the aluminum substrate include rolling streaks formed during rolling of the aluminum substrate which requires a rolling step for its manufacture.
In the practice of the invention, mirror finishing treatment is not subject to any particular limitation, and may be carried out using any suitable method known in the art. Examples of suitable methods include mechanical polishing, chemical polishing, and electrolytic polishing.

Illustrative examples of suitable mechanical polishing methods include polishing with various commercial abrasive cloths, and methods that combine the use of various commercial abrasives (e.g., diamond, alumina) with buffing. Specifically, where an abrasive is used, preferred is a method, for example, whereby the abrasive used is changed as time passes from one having coarser particles to one having finer particles. In such a case, the final abrasive used is preferably one having a grit size of 1500. In this way, a glossiness of at least 50% (in the case of rolled aluminum, at least 50% in both the rolling direction and the transverse direction) can be achieved.

Examples of chemical polishing methods include various methods mentioned in the 6th edition of Aluminum Handbook (Japan Aluminum Association, 2001), pp. 164-165.
Preferred examples include phosphoric acid/nitric acid method, Alupol I method, Alupol V method, Alcoa R5 method, H₃PO₄-CH₃COOH-Cu method and H₃PO₄-HNO₃-CH₃COOH method. Of these, the phosphoric acid/nitric acid method, the H₃PO₄-CH₃COOH-Cu method and the H₃PO₄-HNO₃-CH₃COOH method are especially preferred.
By chemical polishing, a glossiness of at least 70% (in the case of relied aluminum, at least 70% in both the rolling direction and the transverse direction) can be achieved.

Preferred examples of electrolytic polishing methods include various methods mentioned in the 6th edition of Aluminum Handbook (Japan Aluminum Association, 2001), pp. 164-165; the method described in US 2,708,655; and the method described in Jitsumu Hyomen Gijutsu (Practice of Surface Technology), Vol. 33, No. 3, pp. 32-38 (1986).
With electrolytic polishing, a glossiness of at least 70% (in the case of rolled aluminum, at least 70% in both the rolling direction and the transverse direction) can be achieved.

These methods may be suitably combined and used. Specifically, among preferred examples of such combined methods is a method whereby mechanical polishing is carried out by changing the abrasive as time passes from one having coarser particles to one having finer particles, followed by electrolytic polishing.

Mirror finishing treatment enables a surface having, for example, a mean surface roughness Ra of 0.1 µm or less and a glossiness of at least 50% to be obtained. The mean surface roughness Ra is preferably 0.03 µm or less, and more preferably 0.02 µm or less. The glossiness is preferably at least 70%, and more preferably at least 80%.
The glossiness is the specular reflectance that is determined in accordance with JIS Z8741-1997 (Method 3: 60° Specular Gloss) in a direction perpendicular to the rolling direction. Specifically, measurement is carried out using a variable-angle glossmeter (e.g., VG-1D, manufactured by Nippon Denshoku Industries Co., Ltd.) at an angle of incidence/reflection of 60° when the specular reflectance is 70% or less, and at an angle of incidence/reflection of 20° when the specular reflectance is more than 70%.

### [(1) Anodizing Treatment Step]

The anodizing treatment step is a step for anodizing the aluminum substrate to form a micropore-bearing oxide film at the surface of the aluminum substrate.
Conventionally known methods may be used for anodizing treatment in the present invention, but a self-ordering method to be described below is preferably used because the insulating base comprises an anodized film obtained from an aluminum substrate, the anodized film having micropores arrayed so as to have a good degree of ordering as defined by the above equation (i) of preferably at least 70%.
Anodizing treatment is preferably carried out as a constant voltage process.

The self-ordering method is a method that uses the regularly arranging nature of micropores in an anodized film to eliminate factors that may disturb an orderly arrangement and thereby enhance the orderliness. Specifically, an anodized film is formed on high-purity aluminum at a voltage appropriate for the type of electrolytic solution and at a low speed over an extended period of time (e.g., from several hours to well over ten hours).
In this method, because the pore diameter depends on the voltage, a desired pore diameter can be obtained to some extent by controlling the voltage.

In order to form micropores by the self-ordering method, at least the subsequently described anodizing treatment (A) should be carried out. However, micropores are preferably formed by the self-ordering method I or self-ordering method IT.
Next, the self-ordering methods I and II in the preferred embodiments are described in detail.

### [(1-a) Self-Ordering Method I]

According to the self-ordering method I, anodization (anodizing treatment (A)) is followed by complete dissolution of the anodized film using an acid or alkali that dissolves the anodized film (i.e., film removal treatments (B)), which is followed by re-anodization (re-anodizing treatment (C)).
Next, the respective treatments of the self-ordering method I are described in detail.

### <Anodizing Treatment (A)>

A mean flow rate of the electrolytic solution in the anodizing treatment A is preferably from 0.5 m/minute to 20.0 m/minute, more preferably 1.0 m/minute to 15.0 m/minute, and still more preferably from 2.0 m/minute to 10.0 m/minute. By carrying out anodizing treatment (A) at the foregoing flow rate, a uniform and high degree of ordering can be achieved.
The method for causing the electrolytic solution to flow under the above conditions is not subject to any particular limitation. For example, a method involving the use of a common agitator such as a stirrer may be employed. The use of a stirrer in which the stirring speed can be controlled by a digital display is particularly desirable because it enables the average flow rate to be regulated. An example of such a stirrer is the Magnetic Stirrer HS-50D (manufactured by As One Corporation).

Anodizing treatment (A) may be carried out by, for example, a method in which current is passed through the aluminum substrate as the anode in a solution having an acid concentration of from 1 mass% to 10 mass%.
The solution used in anodizing treatment (A) is preferably an acid solution. A solution of sulfuric acid, phosphoric acid, chromic acid, oxalic acid, sulfamic acid, benzenesulfonic acid, amidosulfonic acid, glycolic acid, tartaric acid, malic acid or citric acid is more preferable. Of these, a solution of sulfuric acid, phosphoric acid, or oxalic acid is especially preferred. These acids may be used singly or in combination of two kinds or more thereof.

The conditions for anodizing treatment (A) vary depending on the electrolytic solution employed, and thus cannot be categorically determined. Generally preferred, however, are an electrolyte concentration of from 0.1 mass% to 20 mass%, a solution temperature of from -10°C to 30°C, a current density of from 0.01 A/dm² to 20 A/dm², a voltage of from 3 V to 300 V, and an electrolysis time of from 0.5 hours to 30 hours. An electrolyte concentration of from 0.5 mass% to 15 mass%, a solution temperature of from -5°C to 25°C, a current density of from 0.05 A/dm² o 15 A/dm², a voltage of from 5 V to 250 V, and an electrolysis time of from 1 hour to 25 hours are more preferable. An electrolyte concentration of from 1 mass% to 10 mass%, a solution temperature of from 0°C to 20°C, a current density of from 0.1 A/dm² to 10 A/dm², a voltage of from 10 V to 200 V, and an electrolysis time of from 2 hours to 20 hours are still more preferable.

The treatment time in anodizing treatment (A) is preferably from 0.5 minute to 16 hours, more preferably from 1 minute to 12 hours, and still more preferably from 2 minutes to 8 hours.

Aside from using a constant voltage, anodizing treatment (A) may be carried out using a method in which the voltage is intermittently or continuously varied. In such cases, it is preferable to gradually reduce the voltage. It is thus possible to lower the resistance of the anodized film, forming small micropores in the anodized film. Accordingly, this approach is preferable in that the uniformity is improved, particularly when sealing is carried out by electrodeposition treatment.

According to the present production method, the anodized trim formed by such anodizing treatment (A) preferably has a thickness of 1 to 300 µm, more preferably 5 to 150 µm, and still more preferably 10 to 100 µm.

According to the present production method, the anodized film formed by such anodizing treatment (A) preferably has a mean pore density of 2 million pcs/mm² or more.
The surface coverage of the micropores is preferably in a range of 1% to 60%, more preferably 3% to 50%, and most preferably 5% to 40%.
The surface coverage of the micropores is defined here as the ratio of the total sum of the surface areas of the micropore openings to the surface area of the aluminum surface.

### <film Removal Treatment (B)>

In film removal treatment (B), the anodized film formed at the surface of the aluminum substrate by the above-described anodizing treatment (A) is dissolved and removed.
The subsequently described perforating treatment step may be carried out immediately after an anodized film is formed at the surface of the aluminum substrate by the above-described anodizing treatment (A). However, it is preferred to additionally carry out film removal treatment (B) and the subsequently described re-anodizing treatment (C) in this order after the above-described anodizing treatment (A), followed by the subsequently described perforating treatment step.

Given that the orderliness of the anodized film increases as the aluminum substrate is approached, removal of the anodized film by this film removal treatment (B) causes the lower portion cf the anodized film remaining at the surface of the aluminum substrate to emerge at the surface, obtaining an orderly array of pits. Therefore, in film removal treatment (B), aluminum is not dissolved; only the anodized film made of alumina (aluminum oxide) is dissolved.

Any conventionally known solution may be used without particular limitation for the alumina dissolving solution but the alumina dissolving solution is preferably an aqueous solution containing at least one substance selected from the group consisting of chromium compounds, nitric acid, phosphoric acid, zirconium compounds, titanium compounds, lithium salts, cerium salts, magnesium salts, sodium hexafluorosilicate, zinc fluoride, manganese compounds, molybdenum compounds, magnesium compounds, barium compounds, and uncombined halogens.

Illustrative examples of chromium compounds include chromium (III) oxide and chromium (VI) oxide.
Examples of zirconium compounds include zirconium ammonium fluoride, zirconium fluoride and zirconium chloride.
Examples of titanium compounds include titanium oxide and titanium sulfide.
Examples of lithium salts include lithium fluoride and lithium chloride.
Examples of cerium salts include cerium fluoride and cerium chloride.
Examples of magnesium salts include magnesium sulfide.
Examples of manganese compounds include sodium permanganate and calcium permanganate.
Examples of molybdenum compounds include sodium molybdate.
Examples of magnesium compounds include magnesium fluoride pentahydrate.
Examples of barium compounds include barium oxide, barium acetate, barium carbonate, barium chlorate, barium chloride, barium fluoride, barium iodide, barium lactate, barium oxalate, barium perchlorate, barium selenate, barium selenite, barium stearate, barium sulfite, barium titanate, barium hydroxide, barium nitrate, and hydrates thereof.
Of the above barium compounds, barium oxide, barium acetate and barium carbonate are preferred. Barium oxide is especially preferred.
Examples of uncombined halogens include chlorine, fluorine and bromine.

of the above, the alumina dissolving solution is preferably an acid-containing aqueous solution. Examples of the acid include sulfuric acid, phosphoric acid, nitric acid and hydrochloric acid. A mixture of two or more kinds of acids is also acceptable.
The acid concentration is preferably 0.01 mol/L or more, more preferably 0.05 mol/L or more, and still more preferably 0.1 mol/L or more. Although there is no particular upper limit in the acid concentration, the concentration generally is preferably 10 mol/L or less, and more preferably 5 mol/L or less. A needlessly high concentration is uneconomical, in addition to which higher concentrations may result in dissolution of the aluminum substrate.

The alumina dissolving solution has a temperature of preferably -10°C or more, more preferably -5°C or more, and still more preferably 0°C or more. Treatment using a boiling alumina dissolving solution destroys or disrupts the starting points for ordering. Hence, the alumina dissolving solution is preferably used without being boiled.

The alumina dissolving solution dissolves alumina, but does not dissolve aluminum. Here, the alumina dissolving solution may dissolve a very small amount of aluminum, provided that it does not dissolve a substantial amount of aluminum.

Film removal treatment (B) is carried out by bringing an aluminum substrate bearing the anodized film into contact with the above-described alumina dissolving solution. Examples of the contacting method include, but are not limited to, immersion and spraying. Of these, immersion is preferred.

Immersion is a treatment in which the aluminum substrate bearing the anodized film is immersed in the alumina dissolving solution. Stirring is preferably performed during immersion treatment because thus uniform treatment is possible.
The immersion treatment time is preferably at least 10 minutes, more preferably at least 1 hour, still more preferably at least 3 hours, and most preferably at least 5 hours.

### <Re-Anodizing Treatment (C)>

Removal of the anodized film by the above-described film removal treatment (B) to form well-ordered pits at the surface of the aluminum substrate, followed by the anodizing treatment again, leads to formation of an anodized film having micropores with a still higher degree of ordering.
Re-anodizing treatment (C) may be carried out using a method known in the art, although it is preferably carried out under the same conditions as the above-described anodizing treatment (A).
Alternatively, suitable use may be made of a method in which the current is repeatedly turned on and off while keeping the dc voltage constant, or a method in which the current is repeatedly turned on and off while intermittently varying the dc voltage. Because these methods result in the formation of small micropores in the anodized film, they are preferable for improving uniformity, particularly when sealing is to be carried out by electrodeposition treatment.

When re-anodizing treatment (C) is carried out at a low temperature, the array of micropores is well-ordered and the pore diameter is uniform.
On the other hand, the micropore array may be disturbed and the variance in pore diameter may be held within a given range by performing re-anodizing treatment (C) at a relatively high temperature. The variance in pore diameter may also be controlled by the treatment time.

According to the present production method, the anodized film formed by such anodizing treatment (C) preferably has a thickness of 10 µm to 1000 µm, more preferably 20 µm to 500 µm, and most preferably 30 µm to 150 µm.

According to the production method of the invention, the micropores in the anodized film formed by such anodizing treatment (C) preferably have a pore diameter of 0.01 µm to 0.5 µm, more preferably 0.03 µm to 0.4 µm.
The mean micropore density is preferably at least 2 million pcs/mm².

### [(1-b) Self-Ordering Method II]

According to the self-ordering method II, the surface of the aluminum substrate is anodized (anodizing treatment (D)), the anodized film is partially dissolved by using an acid or alkali (oxide film dissolution treatment (E)) and re-anodizing treatment is carried out to make the micropores grow in the depth direction, after which the anodized film above the inflection points in the cross-sectional shape of the micropores is removed.
Next, the respective treatments of the self-ordering method II are described in detail.

### <Anodizing Treatment (D)>

Conventionally known electrolytic solutions may be used in anodizing treatment (D) but the orderliness of the pore array can be considerably improved by carrying out, under conditions of direct current and constant voltage, anodization using an electrolytic solution in which the parameter R represented by the following general formula (ii) wherein A is the film-forming rate during application of current and B is the film dissolution rate during non-application of current satisfies 160 ≤ R ≤ 200, preferably 170 ≤ R ≤ 190, and most preferably 175 ≤ R ≤ 185.

$R = A \left[nm/s\right] / \left(B \left[nm/s\right]\times applied voltage \left[V\right]\right)$

As in the above anodizing treatment (A), the mean flow rate of the electrolytic solution in anodizing treatment (D) is preferably from 0.5 m/minute to 20.0 m/minute, more preferably 1.0 m/minute to 15.0 m/minute, and still more preferably from 2.0 m/minute to 10.0 m/minute. By carrying out anodizing treatment (D) at the flow rate within the above-defined range, a uniform and high degree of ordering can be achieved.
As in the above-described anodizing treatment (A), the method for causing the electrolytic solution to flow under the above conditions is not subject to any particular limitation. For example, a method involving the use of a common agitator such as a stirrer may be employed. The use of a stirrer in which the stirring speed can be controlled with a digital display is particularly desirable because it enables the average flow rate to be regulated. An example of such a stirrer is the Magnetic Stirrer HS-50D (manufactured by As One Corporation).
The anodizing treatment solution preferably has a viscosity at 25°C and 1 atm of 0.0001 to 100.0 Pa·s and more preferably 0.0005 to 80.0 Pa_{·}s. By carrying out anodizing treatment (D) using the electrolytic solution having the viscosity within the above-defined range, a uniform and high degree of ordering can be achieved.

The electrolytic solution used in anodizing treatment (D) may be an acidic solution or an alkaline solution, but an acidic electrolytic solution is advantageously used in terms of improving the circularity of the pores.
More specifically, as in the above-described anodizing treatment (A), a solution of hydrochloric acid, sulfuric acid, phosphoric acid, chromic acid, oxalic acid, glycolic acid, tartaric acid, malic acid, citric acid, sulfamic acid, benzenesulfonic acid, amidosulfonic acid, glycolic acid, tartaric acrid, malic acid, or citric acid is more preferred. Of these, a solution of sulfuric acid, phosphoric acid or oxalic acid is especially preferred. These acids may be used singly or in combination of two or more kinds thereof by adjusting as desired the parameter in the calculating formula represented by general formula (ii).

The conditions of the anodizing treatment (D) vary depending on the electrolytic solution employed, and thus cannot be categorically determined. Generally preferred, however, are, as in the above anodizing treatment (A), an electrolyte concentration of from 0.1 to 20 mass%, a solution temperature of from -10 to 30°C, a current density of from 0.01 to 20 A/dm², a voltage of from 3 to 500 V, and an electrolysis time of from 0.5 to 30 hours. An electrolyte concentration of from 0.5 to 15 mass%, a solution temperature of from -5 to 25°C, a current density of from 0.05 to 15 A/dm², a voltage of from 5 to 250 V, and an electrolysis time of from 1 to 25 hours are preferred more. An electrolyte concentration of from 1 to 10 mass%, a solution temperature of from 0 to 20°C, a current density of from 0.1 to 10 A/dm², a voltage of from 10 to 200 V, and an electrolysis time of from 2 to 20 hours are still more preferred.

According to the present production method, the anodized film formed by such anodizing treatment (D) preferably has a thickness of 0.1 to 300 µm, more preferably 0.5 to 150 µm, and still more preferably 1 to 100 µm.

According to the present production method, the anodized film formed by such anodizing treatment (D) has a mean pore density of preferably from 2 million pcs/mm².
It is preferable for the micropores to have a surface coverage of from 20 to 50%.

### <Oxide Film Dissolution Treatment (E)>

Oxide film dissolution treatment (E) is a treatment for enlarging the diameter (pore diameter) of the micropores present in the anodized film formed by the above-described anodizing treatment (D) (pore diameter enlarging treatment).

Oxide film dissolution treatment (E) is carried out by bringing the aluminum substrate having undergone the above-described anodizing treatment (D) into contact with an aqueous acid or alkali solution. Examples of the contacting method include, but are not limited to, immersion and spraying. Of these, immersion is preferred.

When oxide film dissolution treatment (E) is to be carried out with an aqueous acid solution, it is preferable to use an aqueous solution of an inorganic acid such as sulfuric acid, phosphoric acid, nitric acid or hydrochloric acid, or a mixture thereof. Particularly preferable is an aqueous solution containing no chromic acid for its high degree of safety. The aqueous acid solution preferably has a concentration of 1 to 10 mass%. The aqueous acid solution preferably has a temperature of 25 to 60°C.
When oxide film dissolution treatment (E) is to be carried out with an aqueous alkali solution, it is preferable to use an aqueous solution of at least one alkali selected from the group consisting of sodium hydroxide, potassium hydroxide and lithium hydroxide. The aqueous alkali solution preferably has a concentration of 0.1 to 5 mass%. The aqueous alkali solution preferably has a temperature of 20°C to 35°C.
Specific examples of solutions that may be preferably used include a 40°C aqueous solution containing 50 g/L of phosphoric acid, a 30°C aqueous solution containing 0.5 g/L of sodium hydroxide, and a 30°C aqueous solution containing 0.5 g/L of potassium hydroxide.
The time of immersion in the aqueous acid solution or aqueous alkali solution is preferably from 8 to 120 minutes, more preferably from 10 to 90 minutes and even more preferably from 15 to 60 minutes.

In oxide film dissolution treatment (E), the amount of enlargement of the pore diameter varies with the conditions of anodizing treatment (D); the ratio of enlargement of the pore diameter between before and after the treatment is preferably 1.05 to 100, more preferably 1.1 to 75, and particularly preferable is 1.2 to 50.

In the self-ordering method II, it is preferred to carry out the above-described anodizing treatment (D) again after the above-described oxide film dissolution treatment (E).

By carrying out anodizing treatment (D) again, oxidation reaction of the aluminum substrate proceeds to yield an aluminum member having an anodized film wherein the micropores have a still greater depth. A barrier layer is present on the aluminum substrate side of the anodized film.

In the self-ordering method II, it is preferred to further carry out the above-described oxide film dissolution treatment (E) after the above-described anodizing treatment (D), oxide film dissolution treatment (E) and anodizing treatment (D) have been carried out in this order.

This treatment enables the treatment solution to enter the micropores to dissolve all the anodized film formed by re-anodizing treatment (D), whereby the micropore formed by re-anodizing treatment (D) may have enlarged diameters.
More specifically, oxide film dissolution treatment (E) carried out again dissolves the interiors of the micropores on the surface side from inflection points in the anodized film, that is, removes the anodized film above the inflection points in the cross-sectional shape of the micropores to obtain an aluminum member having an anodized film bearing straight tube-shaped micropores on the aluminum substrate. A barrier layer is present on the aluminum substrate side of the anodized film.

The amount of enlargement of the pore diameter of the micropores varies with the conditions of anodizing treatment (D); the ratio of enlargement of the pore diameter between before and after the treatment is preferably 1.05 to 100, more preferably 1.1 to 75, and particularly preferable is 1.2 to 50.

The self-ordering method II involves at least one cycle of the above-described anodizing treatment (D) and oxide film dissolution treatment (E). The larger the number of repetitions is, the higher the degree of ordering of the pore array is.
The circularity of the micropores seen from the film surface side is dramatically improved by dissolving in oxide film dissolution treatment (E) all the anodized film formed by the preceding anodizing treatment (D). Therefore, this cycle is preferably repeated at least twice, more preferably at least three times and even more preferably at least four times.
In cases where this cycle is repeated at least twice, the conditions in each cycle of oxide film dissolution treatment and anodizing treatment may be the same or different. Alternatively, the treatment may be terminated with anodizing treatment.

In the production method of the invention, imprinting treatment described later may be preferably used for anodizing treatment in the anisotropic conductive structure producing method.

### [(1-c): Method Using Imprinting]

According to the method using imprinting, a plurality of pits as starting points in micropore formation in anodizing treatment are formed in the surface of the aluminum substrate at predetermined spacings in a predetermined array before performing anodizing treatment for forming a micropore-bearing anodized film on the surface of the aluminum substrate. Formation of such pits facilitates controlling the micropore array and the pore circularity in desired ranges.

The process of forming pits is not particularly limited and exemplary processes include a physical process comprising an imprinting (transfer) process, a particle beam process, a block copolymer process and a resist patterning/exposure/etching process. In imprinting treatment, pits are formed without using electrochemical methods including a procedure used in the self-ordering method (I) in which the anodizing treatment step (A) and film removal treatment (B) are carried out in this order and a procedure in which pits are formed by electrochemical graining treatment.
By forming a plurality of pits as starting points for micropore formation in anodizing treatment at predetermined spacings in a predetermined array, the starting points of micropores formed by anodization can be disposed in a desired array and the resulting structure can have a higher degree of circularity.

### <Physical Process>

Physical processes are exemplified by processes which use' imprinting (transfer processes and press patterning processes in which a plate or roll having projections thereon is pressed against the aluminum substrate to form pits in the substrate). A specific example is a process in which a plate having numerous projections on a surface thereof is pressed against the aluminum substrate surface, thereby forming pits. For example, the process described in JP 10-121292 A may be used.
Another example is a process in which polystyrene spheres are densely arranged on the surface of the aluminum, SiO₂ is vapor-deposited onto the spheres, then the polystyrene spheres are removes and the substrate is etched using the vapor-deposited SiO₂ as the mask, thereby forming pits.

### <Particle Beam Process>

In a particle beam process, pits are formed by irradiating the surface of the aluminum substrate with a particle beam. This process has the advantage that the positions of the pits can be controlled as desired.
Examples of the particle beam include a charged particle beam, a focused ion beam (FIB), and an electron beam.
For example, the process described in JP 2001-105400 A may be used as the particle beam process.

### <Block Copolymer Process>

The block copolymer process involves forming a block copolymer layer on the surface of the aluminum substrate, forming an islands-in-the-sea structure in the block copolymer layer by thermal annealing, then removing the island components to form pits.
For example, the process described in JP 2003-129288 A may be used as the block copolymer method.

### <resist Patterning/Exposure/Etching Process>

In a resist patterning/exposure/etching process, a resist film formed on the surface of the aluminum substrate is exposed and developed by photolithography or electron-beam lithography to form a resist pattern. The resist is then etched, forming pits which pass entirely through the resist to the surface of the aluminum substrate.

Of the above-described various processes for forming pits, a physical process, an FIB process and a resist patterning/exposure/etching process are desirable.

In imprinting treatment, in cases where a plurality of pits are formed is the surface of an aluminum substrate at predetermined spacings in a predetermined array, and particularly in cases where small pits are formed at spacings of about 0.1 µm, it is not economical to apply high-resolution microfabrication technology using electron beam lithography or X-ray lithography each time to form small pits in the aluminum plate surface artificially and orderly. Therefore, it is preferable to use an imprinting (transfer) process in which a substrate having a plurality of projections on the surface is pressed against the surface of the aluminum substrate to be anodized.
More specifically, the imprinting process can be performed by closely attaching a substrate or a roll having projections to the aluminum substrate surface and applying pressure thereto using a hydraulic press. The projections should be formed on the substrate in an array (pattern) corresponding to the array of micropores in the anodized film to be formed by anodizing treatment. The pits may be formed in a periodic array of a regular hexagonal shape or any other pattern such as a partly missing periodic array. It is desirable for the substrate on which the projections are to be formed to have a mirror-finished surface and to have sufficient strength and hardness to prevent breakage or deformation of the projections due to the pressure applied. To this end, substrates of metals such as aluminum and tantalum as well as versatile silicon substrates which are easy in microfabrication can be used but substrates made up of high-strength diamond and silicon carbide can be repeatedly used an increased number of times and is therefore more desirable. Once a substrate or a roll having projections is thus fabricated, it can be repeatedly used to efficiently form an ordered array of pits in a large number of aluminum plates.

In the case of using the imprinting process, the pressure depends on the type of substrate but is preferably from 0.001 to 100 t/cm², more preferably from 0.01 to 75 t/cm² and most preferably from 0.1 to 50 t/cm²
The pressing temperature is preferably from 0 to 300°C, more preferably from 5 to 200°C and most preferably from 10 to 100°C. The pressing time is preferably from 2 seconds to 30 minutes, more preferably from 5 seconds to 15 minutes and most preferably from 10 seconds to 5 minutes.
In terms of fixing the surface profile after pressing, a step of cooling the surface of the aluminum substrate may be added as a post-treatment.

In the method using imprinting, pits are formed in the surface of the aluminum substrate as described above, after which the aluminum substrate surface is anodized.
Conventionally known methods may be used for anodizing treatment, and a method in which treatment is carried out at a constant voltage, a method in which the current is repeatedly turned on and off while keeping the dc voltage constant, and a method in which the current is repeatedly turned on and off while intermittently varying the dc voltage may also be advantageously used.

When anodizing treatment is carried out at a low temperature, the array of micropores is well-ordered and the pore diameter is uniform.
On the other hand, by carrying out anodizing treatment at a relatively high temperature, the micropore array may be disrupted or the variance in pore diameter may be set within a given range. The variance in pore diameter may also be controlled by the treatment time.

In the present invention, the anodized film formed by such anodizing treatment has a thickness of preferably from 30 to 1,000 µm, and more preferably from 50 to 500 µm.

According to the production method of the invention, the micropores in the anodized film formed by such anodizing treatment preferably have a pore diameter of 0.01 to 0.5 µm, more preferably 0.03 to 0.4 µm.
The mean micropore density is preferably at least 2 million pcs/mm².
According to the production method of the invention, any of the treatments (1-a) to (1-c) is preferably carried out in the anodizing treatment step.

### [Constant Current Treatment]

Constant current treatment is performed after the above-described anodizing treatment. This treatment enables the aluminum oxide film to have a larger thickness while increasing the axial length of the micropores without deteriorating the ordered array.

In anodizing treatment at a constant current following the anodizing treatment at a constant voltage, the electrolysis time is preferably from 5 minutes to 30 hours and more preferably from 30 minutes to 5 hours. The current is preferably set to a constant current and is preferably controlled in a fluctuation range of ±10 to 1 A/m².

The type and concentration of the electrolytic solution used in constant current treatment and anodizing treatment, and the temperature conditions may be the same or different.
In anodizing treatment at a constant current following the anodizing treatment at a constant voltage, the current density is preferably from 0 to 10000 A/m², more preferably from 0 to 1000 A/m², and most preferably from 0 to 400 A/m².

### [(2) Perforating Treatment Step]

The perforating treatment step is a step in which micropores formed by anodization are perforated after the above-described anodizing treatment step to obtain the insulating base.
In the perforating treatment step, treatment (2-a) or (2-b) is preferably carried out.
(2-a) Treatment (chemical dissolution treatment) in which an acid or an alkali is used to dissolve the aluminium substrate having the anodized film formed thereon to make the pores extend through the anodized film.
(2-b) Treatment (mechanical polishing treatment) in which the aluminum substrate having the anodized film formed thereon is mechanically polished to make the pores extend through the anodized film.
The treatments (2-a) and (2-b) are described below in detail.

### [(2-a) Chemical Dissolution Treatment]

More specifically, chemical dissolution treatment which follows the anodizing treatment step involves, for example, dissolving the aluminum substrate and, furthermore, removing the bottom of the anodized film for the micropores to extend through the anodized file.

### <Dissolution of Aluminum Substrate>

A treatment solution which does not readily dissolve the anodized film (alumina) but readily dissolves aluminum is used for dissolution of the aluminum substrate after the anodizing treatment step.
That is, use is made of a treatment solution which has an aluminum dissolution rate of at least 1 µm/min, preferably at least 3 µm/min, and more preferably at least 5 µm/min, and has an anodized film dissolution rate of 0.1 nm/min or less, preferably 0.05 nm/min or less, and more preferably 0.01 nm/min or less.
Specifically, a treatment solution which includes at least one metal compound having a lower ionization pendency than aluminum, and which has a pH of 4 or less or 8 or more, preferable 3 or less or 9 or more, and more preferably 2 or less or 10 or more is used for immersion treatment.

Preferred examples of such treatment solutions include solutions which are composed of, as the base, an aqueous solution of an acid or an alkali and which have blended therein a compound of, for example, manganese, zinc, chromium, iron, cadmium, cobalt, nickel, tin, lead, antimony, bismuth, copper, mercury, silver, palladium, platinum or gold (e.g., chloroplatinic acid), or a fluoride or chloride of any of these metals.
Of the above, it is preferable for the treatment solution to be based on an aqueous solution of an acid and to have blended therein a chloride compound.
Treatment solutions of an aqueous solution of hydrochloric acid in which mercury chloride has been blended (hydrochloric acid/mercury chloride), and treatment solutions of an aqueous solution of hydrochloric acid in which copper chloride has been blended (hydrochloric acid/copper chloride) are especially preferred from the standpoint of the treatment latitude.
There is no particular limitation to the composition of such treatment solutions. Illustrative examples of the treatment solutions that may be used include a bromine/methanol mixture, a bromine/ethanol mixture, and aqua regia.

Such a treatment solution preferably has an acid or alkali concentration of 0.01 to 10 mol/L and more preferably 0.05 to 5 mol/L.

In addition, such a treatment solution is used at a treatment temperature of preferably -10°C to 80°C and more preferably 0 to 60°C.

In the production method of the invention, dissolution of the aluminum substrate is carried out by bringing the aluminum substrate having undergone the anodizing treatments step into contact with the above-described treatment solution. Examples of the contacting method include, but are not limited to, immersion and spraying. Of these, immersion is preferred. The period of contact in this process is preferably from 10 seconds to 5 hours, and more preferably from 1 minute to 3 hours.

### [Removal of Bottom of Anodized Film]

The bottom of the anodized film after the dissolution of the aluminum substrate is removed by immersion in an aqueous acid or alkali solution. Removal of the bottom of the anodized film causes the micropores to extend therethrough.

The bottom of the anodized film is preferably removed by the method that involves previously immersing the anodized film in a pH buffer solution to fill the micropores with the pH buffer solution from the micropore opening side, and bringing the surface opposite from the openings (i.e., the bottom of the anodized film) into contact with an aqueous acid solution or aqueous alkali solution.

When this treatment is to be carried out with an aqueous acid solution, it is preferable to use an aqueous solution of an inorganic acid such as sulfuric acid, phosphoric acid, nitric acid or hydrochloric acid, or a mixture thereof. The aqueous acid solution preferably has a concentration of 1 mass% to 10 mass%. The aqueous acid solution preferably has a temperature of 25 to 40°C.
When this treatment is to be carried out with an aqueous alkali solution, it is preferable to use an aqueous solution of at least one alkali selected from the group consisting of sodium hydroxide, potassium hydroxide and lithium hydroxide. The aqueous alkali solution preferably has a concentration of 0.1 to 5 mass%. The aqueous alkali solution preferably has a temperature of 20 to 35°C.

Specific examples of solutions that may be preferably used include a 40°C aqueous solution containing 50 g/L of phosphoric acid, a 30°C aqueous solution containing 0.5 g/L of sodium hydroxide, and a 30°C aqueous solution containing 0.5 g/L off potassium hydroxide.

The time of immersion in the aqueous acid solution or aqueous alkali solution is preferably from 8 to 120 minutes, more preferably from 10 to 90 minutes and even more preferably from 15 to 60 minutes.
In cases where the film is previously immersed in a pH buffer solution, a buffer solution suitable to the foregoing acids/alkalis is used.

### [(2-b) Mechanical Polishing Treatment]

More specifically, mechanical polishing treatment which follows the anodizing treatment step involves, for example, mechanically polishing and removing the aluminum substrate and the anodized film in the vicinity of the aluminum substrate to make the micropores extend through the anodized film.
A wide variety of known mechanical polishing treatment methods may be used for mechanical polishing treatment and, for example, mechanical polishing illustrated for mirror finishing treatment may be used. However, chemical mechanical polishing (CMP) is preferably carried out owing to its high fine polishing rate. CMP treatment may be carried out using a CMP slurry such as PLANERLITE-7000 available from Fujimi Inc., GPX HSC800 available from Hitachi Chemical Co., Ltd., or CL-1000 available from AGC Semi Chemical Co., Ltd.

These perforating treatment steps yield a structure without the aluminum substrate and the barrier layer, that is, an insulating base.

### <Heating Treatment>

Where necessary, a procedure may be performed to heat the insulating base having undergone the perforating treatment in air at 200 °C to 600 °C for 15 minutes to 3 hours to eliminate, for example, distortion and residual water content of the structure.

### [(3) Metal Filling Step]

The material filling step is a step in which a material is filled into the perforated pores in the resulting insulating base after the perforating treatment step to obtain an metal member.
In the conductive material filling step, one of the following treatments (3-a) to (3-c) is preferably carried out.
(3-a) Treatment (immersion treatment) in which the insulating base having the perforated pores is immersed in a solution containing a metal to fill the metal member into the pores.
(3-b) Treatment (electrolytic plating treatment) in which the metal member is filled into the perforated pores by electrolytic plating.
(3-c) Treatment (vapor deposition treatment) in which the metal member is filled into the perforated pores by vapor deposition.
The treatments (3-a) to (3-c) are described below in detail.

### [(3-a) Immersion Treatment]

Known methods such as electroless plating treatment, high viscosity molten metal immersion treatment may be used for the treatment for immersing the insulating base having perforated pores in a solution containing a metal to fill the pores with the metal member. However, electroless plating treatment and molten metal immersion treatment are preferred, and, for ease of handling, electroless plating treatment is preferred.

In electroless plating, known methods and treatment solutions may be used without particular limitation. However, it is preferred to use a method in which nuclei of a metal to be deposited are provided in advance, a compound which may dissolve in a solvent containing the metal and a reducing agent are dissolved in a solution, and the insulating base is immersed in the solution to fill the perforated pores with the metal.
This treatment can be performed in combination with electrolytic plating to be described below.

### [(3-b) Electrolytic Plating Treatment]

Therefore, in the inventive production method, when a metal is filled into the perforated pores by electrolytic plating, it is necessary to provide intermission periods during pulse electrolysis or constant potential electrolysis. The intermission periods must be at least 10 seconds and are preferably from 30 to 60 seconds.
To promote stirring of the electrolytic solution, it is desirable to apply ultrasonic waves.
Moreover, the electrolysis voltage is generally not more than 20 V, and preferably not more than 10 V, although it is preferable to first measure the deposition potential of the target metal in the electrolytic solution to be used and carry out constant potential electrolysis at a potential not more than that potential + 1V. When carrying out constant potential electrolysis, it is desirable to use also cyclic voltammetry. To this end, use may be made of potentiostats such as those available from Solartron, BAS Inc., Hokuto Denko Corporation and Ivium Technologies.

The plating solution may be a conventionally known plating solution.
More specifically, when copper is to be deposited, an aqueous solution of copper sulfate may generally be used. The concentration of copper sulfate is preferably from 1 to 300 g/L, and more preferably from 100 to 200 g/L. Deposition can be promoted by adding hydrochloric acid to the electrolytic solution. In such a case, the concentration of hydrochloric acid is preferably from 10 to 20 g/L.
When gold is to be deposited, it is desirable to carry out plating by alternating current electrolysis using a sulfuric acid solution of a tetrachloroaurate.

### [(3-c) Vapor Deposition Treatment]

In cases where a metal is filled into the perforated pores by vapor deposition, known vapor deposition processes such as physical vapor deposition (PVD) and chemical vapor deposition (CVD) may be used. The conditions of vapor deposition treatment vary with the object to be treated but a temperature of -40°C to 80°C and a degree of vacuum of not more than 10⁻³ Pa are preferred in terms of the vapor deposition rate and a temperature of -20°C to 60°C and a degree of vacuum of not more than 10⁻⁴ Pa are more preferable.

To achieve a uniform filling, a method may also be advantageously used in which the surface of the insulating substrate is appropriately inclined with respect to the direction of vapor deposition to carry out vapor deposition from an oblique direction.

### [(4) Surface Planarization Step]

According to the production method of the invention, the conductive material filling step is preferably followed by the surface planarization step for planarizing the front surface and the back surface of the insulating base. By carrying out the surface planarization step, the front surface and the back surface of the insulating base after the conductive material has been filled can be planarized, and excess metal adhering to the front and back surfaces can be removed.
In the surface planarization step, one of the following treatments (4-a) to (4-c) is preferably carried out.
The treatments (4-a) to (4-c) are described below in detail.
(4-a) Treatment by chemical mechanical polishing (CMP).
(4-b) Electrolytic polishing treatment.
(4-c) Ion milling treatment.

### [(4-a) Treatment by Chemical Mechanical Polishing (CMP)]

CMP treatment may be carried out using a CMP slurry such as PLANERLITE-7000 available from Fujimi Inc., GPX HSC800 available from Hitachi Chemical Co., Ltd., or CL-1000 available from AGC Seimi Chemical Co., Ltd.
It is not preferable to use a slurry for interlayer dielectric films and barrier metals, because the anodized film should not be polished.

### [(4-b) Electrolytic Polishing Treatment]

Examples of electrolytic polishing methods include various methods mentioned in the 6the edition of Aluminum Handbook (Japan Aluminum Association, 2001), pp. 164-165; the method described in US 2,708,655 B; and the method described in Jitsumu Hyomen Gijutsu (Practice of Surface Technology), Vol. 33, No. 3, pp. 32-38 (1986).

### [(4-c) Ion milling treatment]

Ion milling treatment is carried out when more precise polishing than the above-described CMP treatment and electrolytic polishing treatment is necessary, and any known technique may be used. For ion species, argon ion, which is generally used, may be preferably used.

### [(5) Step in Which Heating is Carried Out (heating treatment) in Inert Gas Atmosphere at 300°C or More and 100°C or Less to Improve Crystallinity]

This heating treatment is performed in order to improve crystallinity of the filled metallic portions.
When baking is performed in a vacuum or in inert gas atmosphere with the micropores of the anodized film filled, joining or sintering caused by thermal diffusion among metals does not occur easily, yielding a nanomaterial (nanowires, nanorods) where individuals remain isolated, thus have a good crystallinity (large crystal size), and have a great aspect ratio.
The baking treatment can be carried out preferably at 300°C to 1000°C, more preferably at 400°C to 1000°C, and still more preferably at 500°C to 1000°C, for several seconds to over ten seconds, preferably for several minutes to several hours. The temperature is preferably not higher than a substantial melting point of the metal member and preferably not lower than a substantial softening point thereof.
The term "substantial" is used here to mean the following. Generally, it is known that the melting point and the softening point decrease for fine lines of nano orders, and may exhibit specific values that do not necessarily agree with the solid state property values described in general data book. Accordingly, a temperature at which a state of substantial liquid is reached is regarded as melting point, and a temperature at which a mechanical strength softens is regarded as softening point.

To limit surface oxidation of the metal projecting portions during the heat treatment, it is also effective to carry out the heat treatment at a low temperature or in an atmosphere of inert gas such as nitrogen gas or argon gas or in a vacuum.
When performing heat treatment in a vacuum, the degree of vacuum is preferably 10 to 4 Pa or less, more preferably 10 to 5 Pa or less, and most preferably 10 to 6 Pa.
The vacuum of about 10 to 1 Pa can be easily obtained using a rotary pump. The degree of vacuum of about 10 to 5 Pa can be attained by evaluation with a turbo molecular pump using a metal chamber and a copper gasket.

When heating treatment is performed in inert gas atmosphere, examples of inert gas that may be used include, but are not limited to, He (helium), Ne (neon), Ar (argon), Kr (krypton), Xe (xenon), Rn (radon), and N₂ (nitrogen). Among them, Ar and He are preferable for availability and price.
When an inert gas is used, a preferable pressure is from atmospheric pressure to 10 Pa to 1 Pa. Atmospheric pressure to 1 Pa is particularly preferable.
The heating time is preferably from 0.5 hours to 24 hours, more preferably from 1 hour to 12 hours and even more preferably from 2 hours to 8 hours.
The treatment method may be a continuous treatment or an intermittent treatment and a continuous treatment is preferable in that breakage does not easily occur due to internal stress.
With these materials, electromagnetic anisotropic effect in particular easily manifests itself and decrease in electric resistance, for example, may be expected.

### [(6) Step of Removing a Part or the Whole of Anodized Film

### <Chemical Dissolution Treatments>

In the production method of the invention, the above baking (heating treatment) step (5) is preferably followed by a metal projection step for forming a structure in which the metal members protrude from the front surface and/or back surface of the insulating base. This step yields metal members wherein at least one end of each metal projects from the surface of at least one side of the insulating base, and wherein the ratio of the length to the diameter of the metal of the metal member is 5 or more.
The metal projection step preferably comprises
(6-a) a treatment whereby part of the front surface or back surface of the insulating base is removed to form a structure in which the metal members project from the front surface or back surface of the insulating base, or
(6-b) a treatment whereby metal members are deposited on the surfaces of the metal to form the structure in which the metal members project from the front surface and back surface of the insulating base.

### (6-a) Treatment

A part of the front and/or back surface of the insulating base is brought into contact with an aqueous acid solution or an aqueous alkali solution to dissolve and remove part of the insulating base to form metal members.
The above treatment (6-a) is not limited, provided that the metal member is not dissolved. It is preferred to use an aqueous acid solution or an aqueous alkali solution with which the dissolution rate is readily controlled. When, for example, the metal is copper, an aqueous alkali solution having a pH of at least 13 may be used. For example, an aqueous solution of KOH or NaOH may be suitably used.
When an acid-resistant metal such as a noble metal is used, aqueous solutions of oxalic acid, phosphoric acid, sulfuric acid, and nitric acid may also be used. In this case, a preferable pH range is -1.0 to 3.0, and a preferable pH range is -0.5 to 2.0.
A most preferable pH range is 0 to 1.5. Above all, phosphoric acid is particularly preferable for uniform dissolution. The concentration range is preferably 15 mass% to 1 mass%, preferably 10 mass% to 2 mass, and particularly preferred is 7 mass% to 3 mass%.
To inhabit corrosion of the metal, the solution of the metal may be added with a known corrosion inhibitor as exemplified by an organic substance such as PEG and a strong oxidant such as chromic acid.
A preferable temperature range is 0°C to 70°C; the temperature range is more preferably 10°C to 5C°C, most preferably 20°C to 45°C. A preferable treatment time varies with the metal diameter and the period; a most preferable range is 10 minutes to 60 minutes. The treatment in this time range permits easy control in terms of operation, control, and utility, and improvement of reproducibility for each sample. The viscosity of the treatment liquid is 1.2 to 12 cp; more preferably 2 to 6 cp or 2 to 5 cp, and most preferably 2.5 to 4.8 cp. The viscosity in this range allows the treatment liquid to infiltrate in the interfaces between the insulating base, which is the anodized film, and the metal and thus renders the structure less liable to disintegrate, enabling the projection height of the metal members to be increased.

When the liquid viscosity is low, the treatment liquid infiltrates in the interfaces between the anodized film and the metal and causes the structure to disintegrate. Therefore, a water soluble polymer component is preferably added to improve the viscosity. Examples thereof that may be added include polyethylene glycol (PEG), polyvinyl alcohol (PVA), gelatin, casein, collagen, hyaluronic acid, albumin, gum arabic, arginine carbomer (carboxyvinyl polymer)/carbomer, alginic acid sodium/alginic acid Na, alginic acid propylene glycol/alginic acid propylene glycol, ethyl cellulose, carboxymethyl cellulose sodium/cellulose gum/glycolic acid sodium/xanthane gum, synthesized sodium silicate, dimethyl distearyl ammonium hectorite/quaternium-18hectorite, cyclodextrin/CD, dextrin, and polyacrylic acid sodium/polyacrylic acid Na.
Among others, synthesized products of water soluble polymers such as PEG, PVA, polyacrylic acid sodium, glycerol, and propylene glycol are preferable in terms of, for example, availability, ease of control, stability, and purity. In the case of organic substances, the molecular weight is preferably 40 to 5000, more preferably 60 to 4000, and most preferably 80 to 3000.
As for PEG, for examples, commercially available products thereof having a molecular weight in a range of preferably 40 to 5000, more preferably 80 to 4000, and most preferable 120 to 3000 for ease of adjustment to a preferable viscosity range. (e.g. trade name: MACROGOL manufactured by Sanyo Chemical Industries, Ltd. besides commercially available reagents)

### [Protective Film-Forming Treatment]

In the inventive production method, where the pore diameter changes as time passes by the hydration of the insulating base made of alumina with moisture in the air, protective film-forming treatment may be carried out before the metal filling step.

Illustrative examples of protective films include inorganic protective films containing elemental zirconium and/or elemental silicon, and organic protective films containing a water-insoluble polymer.

### [Nanorod Production Method]

To manfuacture nanorods, the steps of <A1 mirror-finish> to <heating treatment> in the nanopillar producing procedure are likewise performed, and the steps of <heating treatment> and <coating treatment> are followed by <dissolution treatment>. The dissolution treatment is similar to the chemical dissolution treatment in the Step (6) of Removing a Part or the Whole of Anodized Film]

### [Second Metal Members]

The second metal members of the invention are metal members, wherein a part or the whole of the metal members is coated by at least one kind of noble metal, the metal members being nanopillar or nanorod metal members having a diameter of 0.02 µm to 0.4 µm, preferably 0.02 µm to 0.3 µm, a length of 10 µm to 200 µm, and an aspect ratio of 5 or more
The metal members are described below by referring to a preferred example illustrated in FIG. 3. However, the present invention should not be construed as being limited to the following examples.

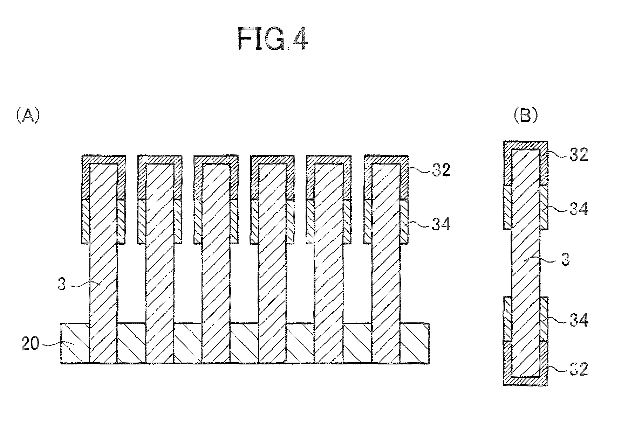

FIG. 3 illustrates a schematic cross section of second metal members of the invention; FIG. 3A illustrates a nanopillar wherein the metal members 3 are regularly arranged on the insulating base 20 and the top portions of the metal members 3 are coated by a first coating (noble metal coating) 32. FIG. 3B illustrates a nanorod, which is a single metal member 3, wherein the top and the bottom portions are coated by the first coating (noble metal coating) 32. FIG. 4A illustrates a nanopillar wherein the columnar metal members 3 are regularly arranged on an insulating base 20 and the top portions of the metal members 3 are coated by the first coating (noble metal coating) 32 and a second coating (a metal different from that of the first coating) 34. FIG. 4B illustrates a nanorod, which is a single metal member 3, wherein the top and the bottom portions are coated by the first coating (noble metal coating) 32 and the second coating 34.
The second metal members of the invention may be held in an insulating base of an anodized film as are the first metal members or may be separate from the base as illustrated in FIG. 3B and FIG. 4B.

Hereinbelow, only characteristic features of the second metal members will be described. The other features are similar to those of the first metal members and will not be described below.
The shape of the second metal members are identical to the shape described of the first metal members and will not be described below.
Similarly to the first metal members, the second metal members 3 may be a metal members 3 obtained by baking in inert gas atmosphere or in a vacuum at 300°C inclusive to 1000°C inclusive (heat treatment) to improve crystallinity or may be metal members 3 not subjected to such treatment.

### <Method of Producing Second Metal Members>

### [(7) Metal Coating Treatment]

The coated metal members are obtained by coating the projecting portions of the metal members formed by the above step (6) of removing a part or the whole of the anodized film with a noble metal.
The method of coating the projecting portions with a noble metal is not specifically limited, provided that the method enables the metal to be coated to a desired thickness, and is exemplified by plating methods such as electrolytic plating, reduced electroless plating, and displacement electroless plating (referred to as displacement plating below); vacuum evaporation; and sputtering. According to the invention, displacement plating is preferable in that only the projecting portions can be selectively coated and a thin coating with a thickness of about several tens of nanometers is possible.
The plating solution used for displacement plating is a solution containing a salt of the metal to be coated such as Au and Ni and preferably containing ion of the metal to be coated having a concentration of 1 g/L to 10 g/L.
The salt of the metal may be exemplified by, for example, potassium gold cyanide, chloroauric acid, and sodium gold sulfite. Among them, sodium gold sulfite is preferable in that plating is performed with a relatively small chemical damage to the plated object. The metallic ion concentration is preferably 1 g/L to 10 g/L. To obtain a uniform and dense film, a range of 1 g/L to 5 g/L is preferable in order to delay the deposition speed intentionally. The value of pH is preferably in a range of 3 to 10 to reduce damage done to the base, and a range of 5 to 9 is particularly preferable. The temperature of the plating solution is preferably 50 C to 95 C to promote plating reaction. Although the coating thickness can be controlled by setting conditions such as said metallic ion concentration, pH, temperature, changing the treatment time is preferred to changing the liquid conditions because the latter may alter the nature of the film (e.g., density). Where the treatment time is changed, the treatment is normally accomplished in about 1 minute to 90 minutes considering the damage to the base or production efficiency. Metal coating needs to be a coating by at least one kind of noble metal; another coating may be by another metal than a noble metal.

The method of coating illustrated in FIG. 4 whereby the first coating and the second coating are effected with different metals may be implemented by providing the whole tip portions of the metal members with the second coating and then further providing the tip portions with the second coating. Alternatively, the tip portions may be provided with the first coating, which is then protected by a resin or the like, followed by coating with the second coating thereby to provide the second coating in other portions than those provided with the first coating. The resin or the like used to protect the first coating is thereafter dissolved and removed using a solvent.

### <Use of Nanopillar and Nanorod of the Invention>

### (1) Anisotropic Conductive Member

The nanorod made of a ferromagnetic body thus obtained is mixed into a resin, followed by application of magnetic fields and orientation process according to a known method to obtain an anisotropic conductive member (ACF). Details are described in JP 2003-109691 A.

### (2) Probe for SPM (Scanning Probe Microscope) and Probe Needle of Probe Card for Semiconductor Inspection

Surface oxidation of a ferromagnetic body such as Fe, which easily corrodes, can be prevented when the ferromagnetic body is coated with a noble metal, which does not easily corrode. Then, the ferromagnetic body can maintain its performance for a long period of time, and thus use thereof for high-density recording media may be expected.

### (3) Magnetic substance for magnetic separation or magnetic chromatography

The nanopillar and the nanorod possess ferromagnetism and corrosion resistance and thus use thereof for a high level of applications such as analysis devices may be expected. (4) Further, when coated with a plurality of noble metals in the form of bar code, the nanopillar and the nanorod are known to manifest a flip-flop behavior such that the optical properties exhibited vary with the angle. Thus, use thereof employing those properties may be expected for nano-barcodes and nano-tags. For example:

### [Nano-barcodes]

A nanowire having a unique pattern produced using a plurality of metals such as gold, silver, and nickel such that the individual wires sensitively respond in a manner comparable to immunoassay method may be used as a compact, high-reliability detector. Details are described in Non-Patent Literature Angewandte Chemie, International Edition, Volume 45, Issue 41, 4 Aug 2006, Pages 6900 - 6904.

### [Nanotags]

Barcodes having a length of the order of sub-microns are known to serve as an excellent label (tags, IDs) in biological detection methods to detect DNAs and proteins. Details are described in Non-Patent Literature Submicrometer Metallic Barcodes, Nicewarner-Peña et al, Science, Pennsylvania State University, 5 October 2001, page 137.

### (5) Optical Resistance Switch

A metal aluminum is anodized, and the diameter is adjusted to 10 nm to 50 nm. Compound semiconductors used for solar cells were embedded in the pores by electrolytic deposition method, a counter electrode with gold was made, and electric properties were measured. The electric resistance greatly changes in response to applied infrared irradiation. Details are described in Non-Patent Literature Applied Physics Letters, 79 (2001), page 4423, N. Kouklin et al, Nebraska University.

### (6) Flip-flop

Flip-flop refers to a phenomenon in which the colors thereof change depending on the angle at which they are observed. Most of the products are composed of multi-layered films. Details are described in Non-Patent Literature Preliminary Drafts, 16C-23, Providing multicolor to A1 anodized film using flip-flop effect, for the 111th Lectures hosted by Surface Finishing Society of Japan.

### (7) Nanowire Brush

The nanopillar structure of the invention may be configured from elongated metallic nanowires. Use of such structure as wire brushes having a sub-micrometer size or a nanometer size may be expected. Such structure may be used, for example, as an assembly of probe needles for removing particles attached to fine wires provided on Si wafers and photomasks. Details are described in JP 2005-84582 A.

### EXAMPLES

### <Production of Nanorod Metal Members>

### (Example 1)

### 1. (a) Electrolytic Polishing Treatment

A high-purity aluminum substrate (Sumitomo Light Metal Industries, Ltd.; purity, 99.99 mass%; thickness, 0.4 mm) was cut to a size of 10 cm square, and then subjected to electrolytic polishing using an electrolytic polishing solution of the composition indicated below at a voltage of 10 V and a solution temperature of 65°C. A carbon electrode was used as the cathode, and a PO-250-30R unit (Takasago, Ltd.) was used as the power supply.

### [Electrolytic Polishing Solution Composition]

| | |
|---|---|
| 85 mass% Phosphoric acid (wake Pure Chemical industries, Ltd.) | 1320 mL |
| Pure water | 30 mL |
| Sulfuric acid | 600 mL |

### 2. (b) Degreasing Treatment

A sample obtained after polishing treatment was degreased by immersion at 60°C for 30 to 90 seconds in a treatment solution containing 1.75 mol/L sodium hydroxide and 0.16 mol/L sodium nitrate.

### 3. (c) Starting Point-Forming Treatment

The sample obtained as above was anodized in an electrolytic solution containing 5.00 mol/L malonic acid for 7.5 minutes under conditions of a voltage of 130.0 V and a solution temperature of 3°C. The voltage was set to a constant voltage mode using GPO-250-30R (Takasago, Ltd.) and controlled to a value of 130.0 V ± 0.1 V. The thus obtained sample was then immersed in an aqueous solution containing 0.52 mol/L phosphoric acid at 40°C for 42.5 minutes to dissolve the film. This treatment was repeated four times.

### 4. (d) Anodizing Treatment

The sample obtained as above was anodized at constant voltage in an electrolytic solution containing 5.00 mol/L malonic acid for 7.5 minutes under conditions of a voltage of 130.0 V and a solution temperature of 3°C.

### 5. (e) Constant Current Treatment

The thus obtained sample was subjected to constant current anodizing treatment using the same type of electrolytic solution containing malonic acid for 90 minutes under conditions of a current density of 120 A/m² and a solution temperature of 3°C. A current transformer and a voltmeter were used to measure the current flowing through the conductor portions and the current was controlled to a value of 120 A/m² ± 10 A/m². An anodized film in which straight tube-shaped micropores were arranged in a honeycomb array on the surface of the aluminum substrate was formed.

### 6. (f) Perforating Treatment Step

Then, the aluminum substrate was dissolved by immersing the aluminum plate having an anodized film obtained in (B) in a treatment solution obtained by blending 0.1 mol/L copper chloride with 20-mass% aqueous hydrochloric acid solution at a solution temperature of 15°C until removal of aluminum was visually confirmed. Further, the whole membrane obtained was immersed for 10 minutes in a 5%-KCl buffer solution, whereupon only the barrier layer side, one of the sides, was immersed in a 0.1 N KOH aqueous solution at 30°C for 30 minutes to remove the bottom portion of the anodized film and thus produce a structure (insulating base) composed of an anodized film having micropores. The structure having undergone perforating treatment had a thickness of 50 µm. This perforating treatment yielded a high-orderliness (degree of ordering = 78%) micropore nanohole structure having a micropore period of 280 nm, a mean micropore diameter of 80 nm, and a micropore length of 50 µm.

### 7. (g) Heating Treatment

Then, the microstructure obtained as above was subjected to a 1-hour heating treatment at 400°C.

### 8. (h) Electrode Film-Forming Treatment

A treatment was then applied to form an electrode film on one surface of the microstructure having undergone the above-described heating treatment. To be more specific, an aqueous solution containing 0.7 g/L chloroauric acid was applied to one of the surfaces, dried at 140°C for 1 minute, and baked at 500°C for 1 hour to form gold plating nuclei. Then, PRECIOUSFAB ACG2000 base solution/reducing solution (produced by Electroplating Engineers of Japan Ltd.) was used as electroless plating solution to effect immersion at 50°C for one hour to form an electrode film having no gap between itself and the surface.

### 9 (i) Metal Filling Step (Ni electrolytic Plating Treatment)

Next, a copper electrode plate was placed in close contact with the surface having the electrode film formed thereon, and electrolytic plating was carried out using the copper electrode as cathode and Ni plate as anode.
Next, a nickel electrode was placed in close contact with the surface having the electrode film formed thereon, and electrolytic plating was carried out using the nickel electrode as cathode and platinum as anode. An electroplating solution, a 300g/L-nickel sulfate solution held at 60°C, was used as an electrolytic solution to carry out constant-voltage pulse electrolysis, thereby filling the perforated pores of the anodized film with nickel.
A plating system manufactured by Yamamoto-MS Co., Ltd. and a power supply (HZ-3000) manufactured by Hokuto Denko Corp. were used to carry out constant-voltage pulse electrolysis. The deposition potential was checked by carrying out cyclic voltammetry in the plating solution, following which electrolysis was carried out, with the film side potential set to -2 V. The pulse waveform in constant-voltage pulse electrolysis was a square waveform. Specifically, electrolysis treatment lasting 60 seconds at a time was repeated five times with a 40-second rest period between treatments so that the total electrolysis treatment time amounted to 300 seconds.
Observation of the surface of the oxide film having its perforated pores filled with nickel using an FE-SEM showed that a part of the nickel apparently oozed out from the surface of the anodized film.

### 10. (j) Surface Planarization Step (both sides)

Subsequently, both surfaces of the anodized film (film thickness 50 µm) having its perforated holes filled with nickel were subjected to mechanical polishing treatment. On the surface of the anodized film on which the electrodes were formed, all the electrodes and the anodized film portion were polished a thickness of 2 µm from the anodized film surface, and on the surface of the anodized film on which no electrodes were formed, polishing was done a thickness of 8µm from the anodized film surface, to planarize the surface of the anodized film. The film thickness of the anodized film after the surface planarization treatment was 40 µm.

### 11. (k) Baking Treatment

One end of a commercially available quartz tube was melted using an oxygen-acetylene burner and sealed; the other end was connected to a thermal diffusion pump to reduce the pressure to a given degree of vacuum and sealed after Ar gas was injected. The other end of the quartz tube connected to the vacuum pump was melted using the burner and sealed. A sample placed in the sealed crystal tube was baked at 800°C in an electric furnace for 3 hours. The temperature increase rate was set to 50°C/10 min. After a given time of baking, slow cooling to a room temperature was effected at temperature decrease rate of 10°C/10 min.

### 12. (1) Dissolution Treatment

As dissolution solution, a KOH aqueous solution was selected.
Concentration 0.1 N, temperature 40°C, and treatment time 4 hours of immersion
A product having a trade name Anodisc provided by Whatman Japan KK, diameter 47, 0.02 µm, was used to perform filtration and washing with water.
Table 1 shows aspect ratios of metal members obtained.

### 13. Evaluation of Crystallinity

Samples were pulverized in a mortar, and powder that passed through a #400 mesh was collected, mixed with polystyrene powder and pressed into the form of a sheet for evaluation of crystallinity.
The pressure-formed sheet was attached to a sample holder made of glass to conduct measuring using a commercially available X-ray diffraction device (RINT TTRIII manufactured by Rigaku Corporation). Measurement conditions were as follows.
Rh tube: 50kV-300mA; divergence slit: open; divergence longitudinal slit: 10 mm; scattering slit: 0.05 mm; light receiving slit: 0.15 mm; scan speed: 4°/min; scan range: 2 θ = 20° to 80°; Scherrer coefficient = 0.9.
The results are shown in Table 1 and Table 2. Evaluation standards are X for crystal size of 50 nm or less, ΔX for 50 nm to 100 nm, Δ for 101 nm to 500 nm, OΔ for 501 nm to less than 1 um, and O for 1 µm or more.

### (Example 2)

The same method as used in Example 1 was repeated to obtain a sample in Example 2 except that micropore-forming treatment by means of the above starting point-forming treatment (c) was performed by anodization in a 0.1 mol/L phosphoric acid electrolytic solution for 240 minutes under conditions of a voltage of 195 V and a solution temperature of 3°C; micropore-forming treatment by means of the above anodizing treatment (d) was performed by constant voltage anodization in 0.5 mol/L phosphoric acid for 30 minutes under conditions of a voltage of 195 V and a temperature of 3°C; and micropore-forming treatment by means of the above constant current treatment (e) was performed by constant current anodization in an 0.5 mol/L phosphoric acid electrolytic solution for 720 minutes under conditions of a current density of 200 A/m² and a solution temperature of 3°C .

### (f) Perforating Treatment Step

Then, the aluminum substrate was dissolved by immersing the aluminum plate having the anodized film obtained in (d) in a treatment solution obtained by blending 0.1 mol/L copper chloride with a 20-mass% aqueous hydrochloric acid solution at a solution temperature of 15°C until removal of aluminum was visually confirmed. Further, the whole membrane obtained was immersed in a 5%-KCl buffer solution for 10 minutes, whereupon only the barrier layer side, one of the sides, was immersed in a 0.1 N KOH aqueous solution at 30°C for 60 minutes to remove the bottom portion of the anodized film and thus produce a structure (insulating base) composed of an anodized film having micropore with an increased pore diameter. The structure having undergone perforating treatment had a thickness of 50 µm. This perforating treatment yielded a high-orderliness (degree of ordering = 84%) anodized film micropore nanohole structure having a micropore period of 498 nm, a mean micropore diameter of 150 nm, and a micropore length of 50 µm.
Under the same conditions as in Example 1 were performed heating treatment (g), electrode film producing treatment (h), metal filling treatment (i), surface planarization treatment (j), baking treatment (k), and dissolution treatment (1). The aspect ratio of metal members obtained was 267 as shown in Table 1.

### (Example 3)

The treatments were the same as in Example 2, except that the constant current treatment (e) was not carried out. In addition, the filling treatment time in the metal filling treatment (i) was curtailed.
A nickel electrode was placed in close contact with the surface having the electrode film formed thereon, and electrolytic plating was carried out using the nickel electrode as cathode and platinum as anode. An electroplating solution, a 300g/L-nickel sulfate solution held at 60°C, was used as an electrolytic solution to carry out constant-voltage pulse electrolysis, thereby filling the perforated pores of the oxide film with nickel.
An electroplating system manufactured by Yamamoto-MS Co., Ltd. and a power supply (Hz-3000) manufactured by Hokuto Denko Corp. were used to carry out constant-voltage pulse electrolysis. The deposition potential was checked by carrying out cyclic voltammetry in the plating solution, following which the film side potential was set to -2 V and electrolysis was carried out. The pulse waveform in constant-voltage pulse electrolysis was a square waveform. Specifically, electrolysis treatments lasting 1 second at a time were carried out a total of five times with 40-second rest periods between treatments so that the total electrolysis treatment time amounted to 5 seconds.
Observation of the cross section of the anodized film having its perforated pores filled with nickel using an FE-SEM showed that filling was partially implemented on the electrode side of the oxide film.
A membrane was obtained with a pore period of 498 nm, Ni filling depth of 750 nm, and a pore diameter of 150 nm. The aspect ratio of the metal members was 5 as shown in Table 1.

### (Examples 4 to 6)

Treatments were effected under the same conditions as in Example 2 except that the temperatures for baking treatment (k) were as shown in Table 1.

### (Example 7)

Treatments were the same as in Example 2 except that the baking treatment step (k) was conducted in N₂ (nitrogen) gas atmosphere in lieu of in a vacuum. The partial pressure was 150 Pa.

### (Example 8)

Treatments were the same as in Example 2 except that the baking treatment step (k) was conducted in Ar gas atmosphere in lieu of in a vacuum. The Ar partial pressure was 150 Pa.

### (Example 9)

### (m) Metal Coating Treatment]

The sample obtained in Example 1 (nanorod) was further subjected to coating treatment with a metal (Ag).
AgCN (Ag concentration 1g/g) and NaCN (Na concentration 4g/L) were used as metal materials in the plating solution with the ratio adjusted to AgCN:NaCN = 1:4 to prepare a solution, in which the nanorod was immersed for 120 seconds at room temperature to carry out displacement plating and obtain an Ag-coated structure. The displacement plating was verified based on the strength ratio of Ni and Ag by ESCA analysis to evaluate the state of coating.

### Comparative Examples 1 and 2

Treatments were effected under the same conditions except that the temperatures for baking treatment (k) in the structure in Example 2 were as shown in Table 1.

### (Comparative Example 3)

Treatments were effected under the same conditions except that the baking treatment (k) in the structure in Example 2 was carried out in air atmosphere.

### (Comparative Example 4)

Treatments were effected under the same conditions as in Example 2 in the structure in Example 2 except that the baking treatment (k) was applied under the conditions as used in Example 2 after formation of a nanopillar comprising arrayed metal members having an aspect ratio of 267 following the dissolution of the anodized film membrane.

Table 1 shows production conditions of the nanorod metal members and the results.
[Table 1]

**Table 1**

| Examples | Anodized film membrane structure (mean value) | | Kind of metal | Metallic member aspect ratio | Baking conditions | | Crystallinity | Fusion of nanorods | Metallic member surface oxidation | Detachment of nanorods |
|---|---|---|---|---|---|---|---|---|---|---|
| | Microscope period [nm] | Microscope diameter [nm] | | | Vacuum [Pa] | Baking temperature [°C] | | | | |
| 1 | 300 | 80 | Ni | 500 | 0.01 | 800 | ○ | ○ | ○ | ○ |
| 2 | 498 | 150 | ↓ | 267 | 0.01 | 800 | ○ | ○ | ○ | ○ |
| 3 | ↓ | ↓ | ↓ | 5 | 0.01 | 800 | ○ | ○ | ○ | ○ |
| 4 | ↓ | ↓ | ↓ | 267 | 0.01 | 1000 | ○ | ○ | ○ | ○ |
| 5 | ↓ | ↓ | ↓ | ↓ | 0.01 | 600 | ○ | ○ | ○ | ○ |
| 6 | ↓ | ↓ | ↓ | ↓ | 0.01 | 400 | △ | ○ | ○ | ○ |
| 7 | ↓ | ↓ | ↓ | ↓ | N₂ | 800 | △ | ○ | ○ | ○ |
| 8 | ↓ | ↓ | ↓ | ↓ | Ar | 800 | △ | ○ | ○ | ○ |
| CE 1 | ↓ | ↓ | ↓ | 267 | 0.01 | 200 | x | ○ | ○ | ○ |
| CE 2 | ↓ | ↓ | ↓ | 267 | 0.01 | 1300 | ○ | ○ | ○ | X |
| CE 3 | ↓ | ↓ | ↓ | 267 | Air | 800 | ○ | ○ | X | ○ |
| CE 4 | ↓ | ↓ | ↓ | 267 | Baking after removal of anodized film | | ○ | X | ○ | ○ |
| | | | | | 0.01 | 800 | | | | |

### <Production of Nanorod Metal Members>

### (Example 10)

Elctrolytic polishing treatment(a), degreasing treatment(b), starting point forming treatment(c), anodizing treatment(d), constant current treatment(e), perforating treatment(f),heating treatment(g), electrode film forming treatment (h), metal filling treatment (i), and surface planarizing treatment (j) were carried out under the same conditions as in Example 2 so that the aspect ratio of the metal members obtained was the value shown in Table 2.
The baking treatment (k) was carried out under the following conditions.
One end of a commercially available quartz tube was melted using an oxygen-acetylene burner and sealed; the other end was connected to a thermal diffusion pump to reduce the pressure to a given degree of vacuum and sealed after Ar gas was injected. The other end of the quartz tube connected to the vacuum pump was melted using the burner and sealed. A sample placed in the sealed crystal tube was baked at 300°C in an electric furnace for 3 hours. The temperature increase rate was set to 50°C/10 min. After a given time of baking, slow cooling to room temperature was effected at temperature decrease rate of 10°C/10 min.
The dissolution treatment (1) was carried out under the following conditions.
Dissolving solution: aqueous KOH solution
Concentration: 0.1 N
Temperature: 40°C
Additive: PEG (polyethylene glycol: molecular weight 1000)
Treatment time: 1 hour of immersion
immersion was implemented so that only one side comes into contact.

### 13. Evaluation of Crystallinity

Samples were pulverized in a mortar, and powder that passed through a #400 mesh was collected, mixed with polystyrene powder, and pressed into the form of a sheet to evaluate crystallinity. The pressure-formed sheet was attached to a sample holder made of glass to conduct measuring using a commercially available X-ray diffraction device (RINT TTRIII manufactured by Rigaku Corporation). Measurement Conditions:
Rh tube: 50kV-300mA; divergence slit: open; divergence
longitudinal slit: 10 mm; scattering slit: 0.05 mm; light
receiving slit: 0.15 mm; scan speed: 4°/min; scan range: 2 θ = 20°to 80°; Scherrer coefficient = 0.9.

### (Examples 11 to 13)

Treatments were carried out as in Example 10 except that the temperature in baking treatment (k) was changed.

### (Comparative Example 5)

Treatments were carried out as in Example 10 except that the temperature in baking treatment (k) was changed to 200°C.

### Crystallinity of Comparative Example 5

Measurement with XRD revealed no observable half-value, narrow peak indicating a good crystallinity. The crystal size was 50 nm or less. Measurement with XRD did not reveal presence of oxides resulting from pillar surface oxidation.

### (Comparative Example 6)

Treatments were carried out as in Example 10 except that the temperature in baking treatment (k) was changed to 1100°C.
The sample heated at 1100°C was observed with a SEM for its configuration, revealing that the metal portions were deformed into spheres or indefinite shapes to such an extent that they can no longer serve as a pillar.
The results are shown in Table 2.

[Table 2]

**Table 2**

| Exmaples | Anodized film membrane structure | | Kind of metal | Metallic member aspect ratio | Baking conditions | | Crystallinity | Metallic member surface oxidation | Nanopillar deformation |
|---|---|---|---|---|---|---|---|---|---|
| | Period [nm] | Micropore diameter [nm] | | | Vacuum [Pa] | Baking temperature [°C] | | | |
| 10 | 498 | 150 | N1 | 333 | 0.01 | 300 | △ | ○ | ○ |
| 11 | ↓ | ↓ | ↓ | ↓ | 0.01 | 600 | △ | ○ | ○ |
| 12 | ↓ | ↓ | ↓ | ↓ | 0.01 | 800 | ○ | ○ | ○ |
| 13 | ↓ | ↓ | ↓ | ↓ | 0.01 | 1000 | ○ | ○ | ○ |
| CE 5 | ↓ | ↓ | ↓ | ↓ | 0.01 | 200 | x | ○ | ○ |
| CE 6 | ↓ | ↓ | ↓ | ↓ | 0.01 | 1100 | ○ | ○ | x |

### Reference Signs List

- 2, 20: insulating base
- 3: metal member
- 6: thickness of insulating base
- 7: width between metal members
- 8: diameter of metal members
- 9: center-to-center distance (pitch) between metal members
- 30: length of metal members
- 32: first coating (noble metal coating)
- 34: second coating

## Claims

1. Metal members produced by filling a metal having an aspect ratio of 5 or more in micropores of an anodized film having a degree of ordering of 70% or more, followed thereafter by baking in inert gas atmosphere or in a vacuum at a temperature from 300°C or more to 1000°C or less to improve crystallinity.

2. Nanopillar metal members or nanorod metal members that are metal members having an aspect ratio of 5 or more produced by filling micropores of an anodized film having a degree of ordering of 70% or more with a metal having an aspect ratio of 5 or more, followed by baking in inert gas atmosphere or in a vacuum at a temperature from 300°C or more to 1000°C or less to improve crystallinity and removing the anodized film.

3. Metal members wherein a part or a whole of metal members are coated by at least one kind of noble metal, the metal members being nanopillar or nanorod metal members having a diameter of 0.02 µm to 0.4 µm, a length of 10 µm to 200 µm, and an aspect ratio of 5 or more.

4. A method of producing metal members having an aspect ratio of 5 or more, the method comprising filling a metal in the micropores of an anodized film to an aspect ratio of 5 or more, followed by baking in inert gas atmosphere or in a vacuum at a temperature from 300°C or more to 1000°C or less to improve crystallinity and removing the anodized film.

5. A method of producing nanopillar or nanorod metal members comprising filling a metal in the micropores of an anodized film to an aspect ratio of 5 or more, melting a part of the anodized film to expose the metal, coating an exposed region with a different kind of metal, and thereafter melting the anodized film.

6. the method of producing a metal member according to Claim 5, wherein the step of melting a part of the anodized film to expose the metal and the step of coating the exposed region with a different kind of metal are repeated twice or more.

7. A probe needle using the metal members described in Claim 1 or 3.

8. A magnetic substance for magnetic separation or magnetic chromatography using the metal members described in Claim 1 or 3.

9. A nanobarcode using the metal members described in Claim 3.

10. An anisotropic conductive member obtained by orientating the nanorods described in Claim 2 or 3 in a resin using magnetic fields.
